# EUROPEAN PATENT APPLICATION

(11) **EP 2 219 074 A1**
(43) Date of publication of application: **18.08.2010**
(21) Application number: 10001058.6
(22) Date of filing: 02.02.2010
(51) Int. Cl.: G03F 7/00, G03F 7/32

(54) **Processing solution for developing lithographic printing plate precursor and method of preparing lithographic printing plate**

(30) Priority: 16.02.2009 JP 2009033145
(71) Applicant: FUJIFILM Corporation, Minato-ku Tokyo (JP)
(72) Inventor: Hirano, Mitsunori, Haibara-gun Shizuoka (JP); Adachi, Keiichi, Haibara-gun Shizuoka (JP); Wariishi, Koji, Haibara-gun Shizuoka (JP); Fujii, Shigekatsu, Haibara-gun Shizuoka (JP)
(74) Representative: HOFFMANN EITLE

(57) **Abstract**

A processing solution for developing a lithographic printing plate precursor, contains a compound represented by the following formula (1) and a compound represented by the following formula (2): 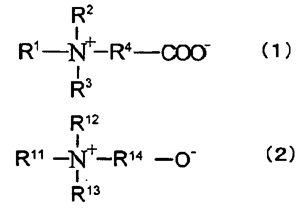 wherein, R¹ and R¹¹ each independently represents a hydrogen atom, an alkyl group or an alkyl group containing a connecting group which is selected from an ester bond, a carbonyl bond and an amido bond, provided that when R¹ and R¹¹ each independently represents an alkyl group or an alkyl group containing a connecting group, a total number of carbon atoms included is from 8 to 20, R² and R¹² each independently represents a hydrogen atom or an alkyl group, R³ and R¹³ each independently represents a group containing an ethylene oxide group or an alkyl group, and R⁴ and R¹⁴ each independently represents an alkylene group or a single bond.

## Description

### FIELD OF THE INVENTION

The present invention relates to a processing solution for developing a lithographic printing plate precursor, more specifically, to a processing solution for developing a lithographic printing plate precursor having high processing ability. Further, the present invention relates to a method of preparing a lithographic printing plate using the processing solution, particularly, to a method of preparing a lithographic printing plate having high processing ability and enabling processing by one solution using the processing solution.

### BACKGROUND OF THE INVENTION

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous alkali solution having pH of 11 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

In response to the above situation, for instance, processing with a processing solution having pH of 11. 9 to 12.1 and containing a water-soluble polymer compound is described in the example of EP-A-1868036. However, since the printing plate obtained by the processing is left in the state that the alkali of pH 12 adheres on the surface thereof, a problem in view of safety of an operator arises and with the lapse of long time after the preparation of printing plate until the initiation of printing, the image area gradually dissolves to result in deterioration in printing durability or ink-receptive property. In JP-T-2007-538279 (the term "JP-T" as used herein means a published Japanese translation of a PCT patent application), processing with a processing solution having pH of 3 to 9 and containing a water-soluble polymer compound is described. However, since the processing solution does not contain a base component, it is necessary to enable development by making a polymer used in a photosensitive layer hydrophilic and thus, a problem occurs in that printing durability severely degrades. In JP-A-2008-276166 (the term "JP-A" as used herein means an "unexamined published Japanese patent application"), a method of developing with a developer having pH of 2 to 10 and containing a nitrogen-containing surfactant is described.

### SUMMARY OF THE INVENTION

Therefore, an object of the present invention is to provide a method of preparing a lithographic printing plate which overcomes the problems of the prior art. More specifically, it is to provide a processing solution for developing a lithographic printing plate precursor which exhibits excellent surface state, developing property and processing ability even in one solution processing by an aqueous solution having pH of 8.5 to 10.5 and a method of preparing a lithographic printing plate using the processing solution for developing a lithographic printing plate precursor.

As a result of the intensive investigations, the inventor has found that the above-described object can be achieved by using a processing solution having a prescribed composition to complete the present invention.

Specifically, the present invention includes the following items.
<1> A processing solution for developing a lithographic printing plate precursor comprising a compound represented by formula (1) shown below and a compound represented by formula (2) shown below: 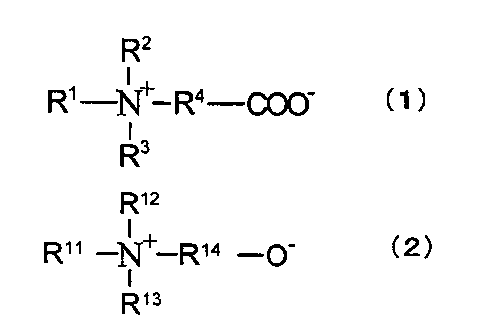 In formulae (1) and (2), R¹ and R¹¹ each independently represents a hydrogen atom, an alkyl group or an alkyl group containing a connecting group which is selected from an ester bond, a carbonyl bond and an amido bond, provided that when R¹ and R¹¹ each independently represents an alkyl group or an alkyl group containing a connecting group, a total number of carbon atoms included is from 8 to 20, R² and R¹² each independently represents a hydrogen atom or an alkyl group, R³ and R¹³ each independently represents a group containing an ethylene oxide group or an alkyl group, and R⁴ and R¹⁴ each independently represents an alkylene group or a single bond.
<2> The processing solution for developing a lithographic printing plate precursor as described in <1> above, wherein at least any one of the compound represented by formula (1) and the compound represented by formula (2) has an amido bond.
<3> The processing solution for developing a lithographic printing plate precursor described in <1> or <2> above, wherein a mixing ratio (weight ratio) of the compound represented by formula (1) and the compound represented by formula (2) is from 5:95 to 95:5.
<4> The processing solution for developing a lithographic printing plate precursor as described in any one of <1> to <4> above, which has pH of 8.5 to 10.5.
<5> A method of preparing a lithographic printing plate, comprising imagewise exposing a negative type lithographic printing plate precursor comprising a hydrophilic support and a photosensitive layer containing (i), (ii), (iii) and (iv) shown below and then developing the exposed lithographic printing plate precursor with the processing solution for developing a lithographic printing plate precursor as described in any one of <1> to <4> above:
   (i) a sensitizing dye,
   (ii) a photopolymerization initiator,
   (iii) a polymerizable compound,
   (iv) a binder polymer.
<6> The method of preparing a lithographic printing plate as described in <5> above, wherein the development with the processing solution for developing a lithographic printing plate precursor is conducted by one solution.
   According to the present invention, by using the compound represented by formula (1) together with the compound represented by formula (2) in a developer, even in development of a lithographic printing plate precursor by one solution processing, excellent advantages are obtained in that surface state of a lithographic printing plate after development is good, in that due to good developing property, printed materials without unevenness in halftone dots are obtained, in that occurrence of scum in a developing tank is prevented and in that degradation of printing durability due to preservation of a lithographic printing plate after development processing hardly occur.

### BRIEF DESCRIPTION OF THE DRAWING

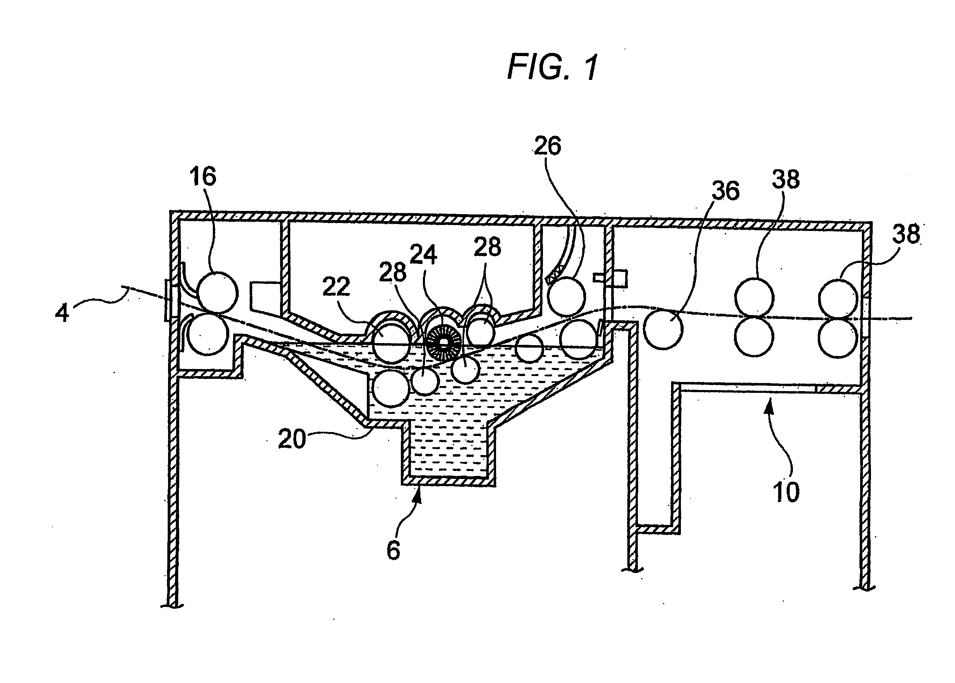

Fig. 1 is an illustration showing a structure of an automatic development processor.

### [Description of reference numerals and signs]

- 4:: Lithographic printing plate precursor
- 6:: Developing unit
- 10:: Drying unit
- 16:: Transport roller
- 20:: Developing tank
- 22:: Transport roller
- 24:: Brush roller
- 26:: Squeeze roller
- 28:: Backup roller
- 36:: Guide roller
- 38:: Skewer roller

### DETAILED DESCRIPTION OF THE INVENTION

The processing solution for developing a lithographic printing plate precursor and method of preparing a lithographic printing plate according to the present invention will be described in detail below. The processing solution (hereinafter, also simply referred to as a "processing solution") for developing a lithographic printing plate precursor is characterized by containing the compound represented by formula (1) and the compound represented by formula (2)

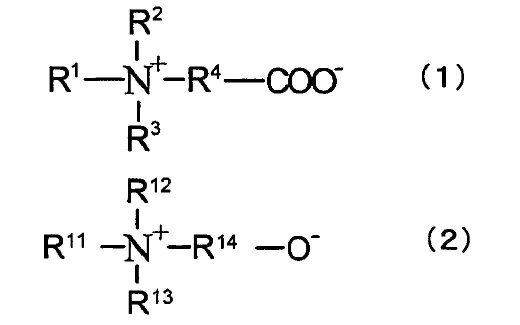

In formulae (1) and (2), R¹ and R¹¹ each independently represents a hydrogen atom, an alkyl group or an alkyl group containing a connecting group which is selected from an ester bond, a carbonyl bond and an amido bond, provided that when R¹ and R¹¹ each independently represents an alkyl group or an alkyl group containing a connecting group, a total number of carbon atoms included is from 8 to 20, R² and R¹² each independently represents a hydrogen atom or an alkyl group, R³ and R¹³ each independently represents a group containing an ethylene oxide group or an alkyl group, and R⁴ and R¹⁴ each independently represents an alkylene group or a single bond.
In the compound represented by formula (1) or the compound represented by formula (2), as the total number of carbon atoms increases, the hydrophobic portion becomes large and dissolution of the compound in an aqueous developer becomes difficult. In such a case, the dissolution is improved by adding a dissolution auxiliary agent for assisting the dissolution, for example, an organic solvent, e.g., an alcohol. However, when the total number of carbon atoms excessively increases, the compound can not be dissolved in the proper mixing range in some cases. Therefore, the total number of carbon atoms included in R¹ to R⁴ or R¹¹ to R¹⁴ is preferably from 10 to 40, and more preferably from 12 to 30.
The alkyl group containing a connecting group represented by R¹ or R¹¹ represents a structure where a connecting group is present in an alkyl group. Specifically, when only one connecting group is present in an alkyl group, the alkyl group containing a connecting group is represented by "-alkylene group-connecting group-alkyl group". Although two or more connecting groups may present, it is preferred that one connecting group is present. Of the connecting groups, an amido group is particularly preferable. A total number of carbon atoms included in the alkylene group bonding to the connecting group is preferably from 1 to 5. The alkylene group may be straight-chain or branched and is preferably a straight-chain alkenylene group. A total number of carbon atoms included in the alkyl group bonding to the connecting group is preferably from 3 to 19. The alkyl group may be straight-chain or branched and is preferably a straight-chain alkyl group.
In the alkyl group or the alkyl group containing a connecting group represented by R¹ or R¹¹, a total number of carbon atoms is from 8 to 20.
When R² or R¹² represents an alkyl group, a total number of carbon atoms is preferably from 1 to 5, and particularly preferably from 1 to 3. The alkyl group may be straight-chain or branched and is preferably a straight-chain alkyl group.
When R³ or R¹³ represents an alkyl group, a total number of carbon atoms is preferably from 1 to 5, and particularly preferably from 1 to 3. The alkyl group may be straight-chain or branched and is preferably a straight-chain alkyl group.
When R³ or R¹³ represents a group containing an ethylene oxide group, the group is represented by -Ra(CH₂CH₂O)nRb, wherein Ra represents a single bond, an oxygen atom or a divalent organic group (preferably having 10 or less carbon atoms), Rb represents a hydrogen atom or an organic group (preferably having 10 or less carbon atoms), and n is 1 to 10.
When R⁹ or R¹⁴ represents an alkylene group, a total number of carbon atoms is preferably from 1 to 5, and particularly preferably from 1 to 3. The alkylene group may be straight-chain or branched and is preferably a straight-chain alkylene group.
It is preferred that at least any one of the compound represented by formula (1) and the compound represented by formula (2) has an amido bond. More preferably, the connecting group present in the alkyl group represented by R¹ or R¹¹ is an amido bond.
Representative examples of the compound represented by formula (1) and the compound represented by formula (2) are set forth below.

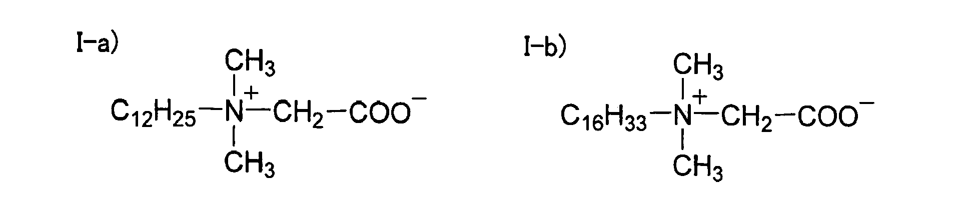

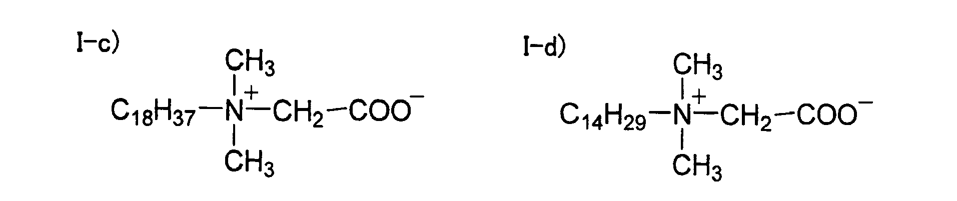

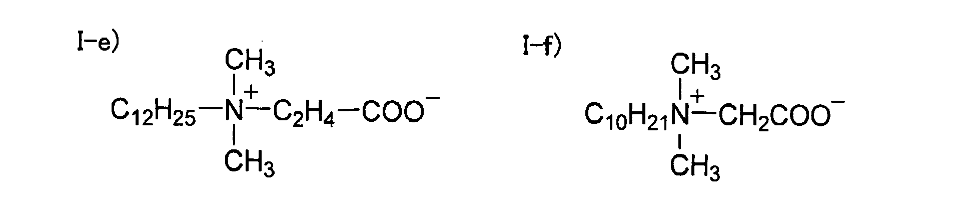

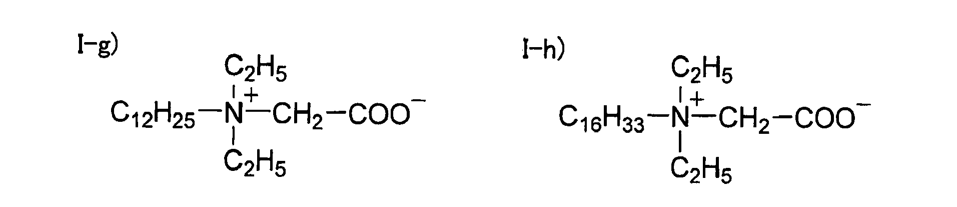

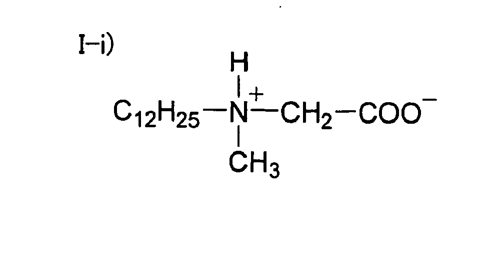

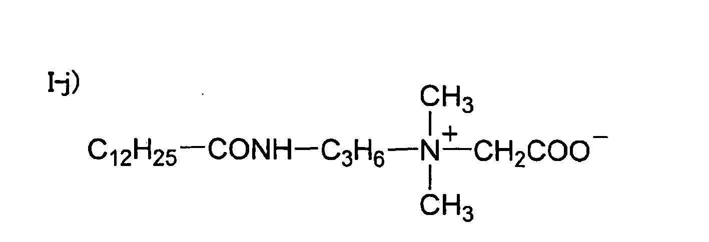

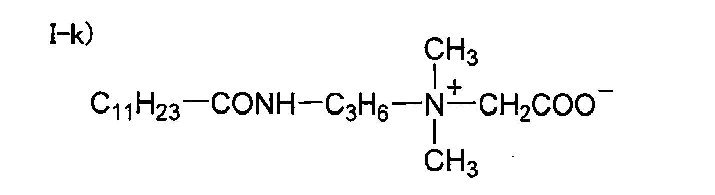

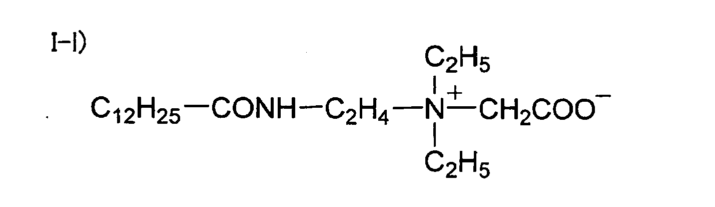

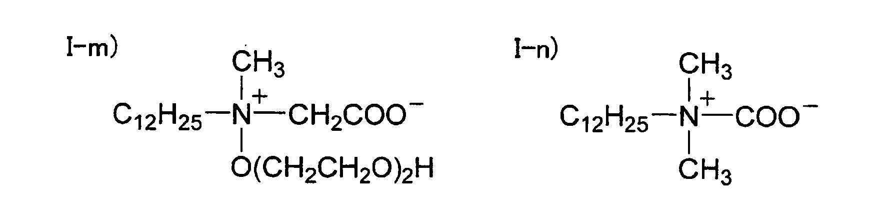

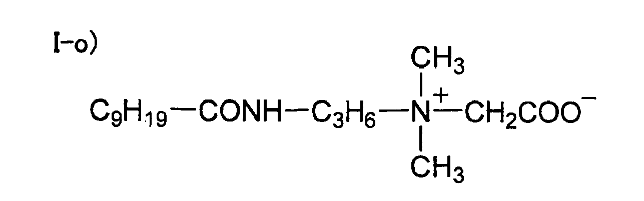

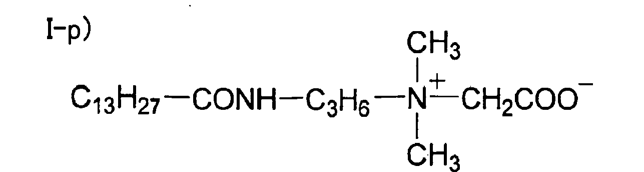

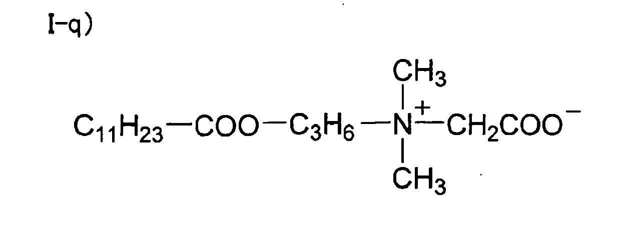

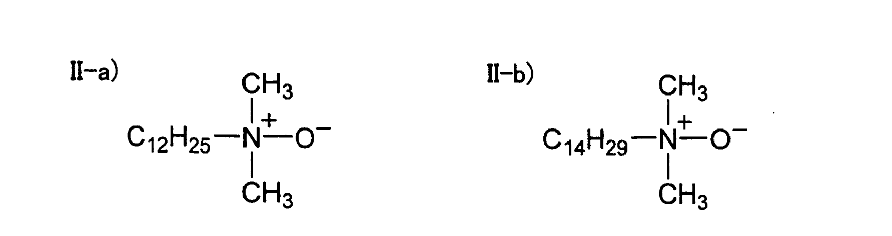

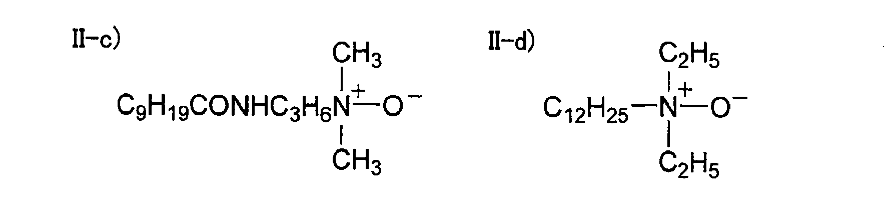

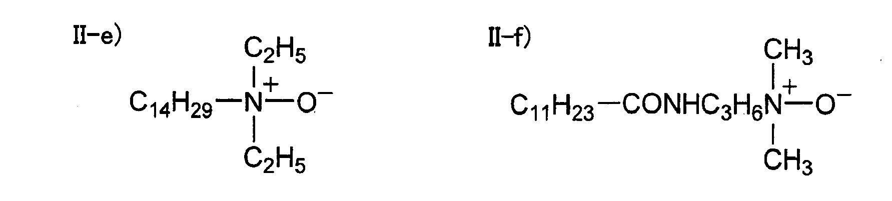

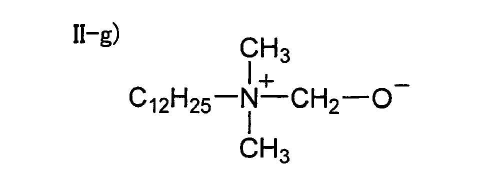

The compound represented by formula (1) and the compound represented by formula (2) are used in combination and a total amount of the compound represented by formula (1) and the compound represented by formula (2) is preferably from 0.01 to 15% by weight, more preferably from 0.5 to 10% by weight, in the processing solution.

A mixing ratio of the compound represented by formula (1) and the compound represented by formula (2) is not particularly restricted as far as both compounds are present. A weight ratio (compound represented by formula (1) : compound represented by formula (2)) is preferably from 5:95 to 95:5, more preferably from 10:90 to 90:10, and most preferably from 50:50 to 85:15.

The compound represented by formula (1) and the compound represented by formula (2) can be synthesized according to a known method. The compounds synthesized may be used and the compounds commercially available may also be used. As for the compound commercially available, the compound represented by formula (1) includes, for example, Softazoline LPB, Softazoline LPB-R and Vista MAP produced by Kawaken Fine Chemicals Co, Ltd. and Takesaaf C-157L produced by Takemoto oil & Fat Co., Ltd. The compound represented by formula (2) includes, for example, Softazoline LAO produced by Kawaken Fine Chemicals Co, Ltd. and Amogen AOL produced by Dai-ichi Kogyo Seiyaku Co., Ltd.

The processing solution for use in the invention is ordinarily an aqueous solution having pH of 2 to 11. It is preferably an aqueous solution containing water as a main component (containing 60% by weight or more of water). In particular, an aqueous solution containing a surfactant (for example, an anionic, nonionic or cationic surfactant) other than the compound represented by formula (1) and the compound represented by formula (2) or an aqueous solution containing a water-soluble polymer compound is preferable. An aqueous solution containing both the surfactant and the water-soluble polymer compound is also preferable.

The pH of the processing solution is preferably from 7 to 10.8, and more preferably from 8.5 to 10.5.

The anionic surfactant which may be used together is not particularly restricted and preferably includes a dialkylsulfosuccinic acid salt, an alkyl sulfate ester salt, an alkylnaphthalenesulfonic acid salt, an alkyldiphenyletherdisulfonic acid salt and an alkylbenzenesulfonic acid salt.

The cationic surfactant which may be used together is not particularly restricted and heretofore known cationic surfactants can be used. Examples of the cationic surfactant include an alkylamine salt, a quaternary ammonium salt, a polyoxyethylene alkyl amine salt and a polyethylene polyamine derivative.

The nonionic surfactant which may be used together is not particularly restricted and preferably includes an ethylene oxide addact of sorbitol and/or sorbitan fatty acid ester, a polypropylene glycol ethylene oxide addact, a dimethylsiloxane-ethylene oxide block copolymer, a dimethylsiloxane-(propylene oxide-ethylene oxide) block copolymer and a fatty acid ester of polyhydric alcohol.

In case of using the other surfactant in the processing solution according to the invention, the amount thereof is preferably from 0.1 to 5% by weight, based on the total amount of the compound represented by formula (1) and the compound represented by formula (2).

The water-soluble polymer compound for use in the processing solution according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, Soyafive (trade name, produced by Fuji Oil Co., Ltd.) is available and various grade products can be used. The soybean polysaccharide preferably used is that having viscosity (at 25°C) in a range of 10 to 100 mPa/sec in the 10% by weight aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more of the water-soluble polymer compounds may be used in combination. The content of the water-soluble polymer compound is preferably from 0.1 to 20% by weight, more preferably from 0.5 to 10% by weight, in the processing solution.

Into the processing solution for use in the invention, a pH buffer agent may further be incorporated.

As the pH buffer agent used in the invention, a pH buffer agent exhibiting a pH buffer function at pH of 2 to 11 is used without particular restriction. In the invention, a weak alkaline buffer agent is preferably used and includes, for example, (a) a carbonate ion and a hydrogen carbonate ion, (b) a borate ion, (c) a water-soluble amine compound and an ion of the water-soluble amine compound, and combinations thereof. Specifically, for example, (a) a combination of a carbonate ion and a hydrogen carbonate ion, (b) a borate ion, or (c) a combination of a water-soluble amine compound and an ion of the water-soluble amine compound exhibits a pH buffer function in the processing solution to prevent fluctuation of the pH even when the processing solution is used for a long period of time. As a result, for example, the deterioration of developing property resulting from the fluctuation of pH and the occurrence of development scum are restrained. The combination of a carbonate ion and a hydrogen carbonate ion is particularly preferable.

In order for a carbonate ion and a hydrogen carbonate ion to be present in the processing solution, a carbonate and a hydrogen carbonate may be added to the processing solution or a carbonate ion and a hydrogen carbonate ion may be generated by adding a carbonate or a hydrogen carbonate to the processing solution and then adjusting the pH. The carbonate or hydrogen carbonate used is not particularly restricted and it is preferably an alkali metal salt thereof. Examples of the alkali metal include lithium, sodium and potassium and sodium is particularly preferable. The alkali metals may be used individually or in combination of two or more thereof.

When the combination of (a) a carbonate ion and a hydrogen carbonate ion is adopted as the pH buffer agent, the total amount of the carbonate ion and hydrogen carbonate ion is preferably from 0. 05 to 5 mole/1, more preferably from 0.1 to 2 mole/l, particularly preferably from 0.2 to 1 mole/1, in the processing solution.

The processing solution according to the invention may contain an organic solvent. As the organic solvent to be contained, for example, an aliphatic hydrocarbon (e.g., hexane, heptane, Isopar E, Isopar H, Isopar G (produced by Esso Chemical Co., Ltd.), gasoline or kerosene), an aromatic hydrocarbon (e.g., toluene or xylene), a halogenated hydrocarbon (methylene dichloride, ethylene dichloride, trichlene or monochlorobenzene) or a polar solvent is exemplified.

Further, when the organic solvent is insoluble in water, it may be employed by being solubilized in water using a surfactant or the like. In the case where the processing solution contains an organic solvent, the concentration of the organic solvent is desirably less than 40% by weight in view of safety and inflammability.

The processing solution for use in the invention may contain a preservative, a chelating agent, a defoaming agent, an organic acid, an inorganic acid, an inorganic salt or the like in addition the components described above. Specifically, compounds described in Paragraph Nos. [0266] to [0270] of JP-A-2007-206217 are preferably used.

The processing solution described above can be used as a developer and a development replenisher for an exposed negative type lithographic printing plate precursor and it is preferably applied to an automatic processor described hereinafter. In the case of conducting the development processing using an automatic processor, the processing solution becomes fatigued in accordance with the processing amount, and hence the processing ability may be restored using a replenisher or a fresh processing solution.

The development processing using the processing solution according to the invention is preferably performed by an automatic processor equipped with a supplying means for the processing solution and a rubbing member. An automatic processor using a rotating brush roll as the rubbing member is particularly preferred. Further, the automatic processor is preferably provided with a means for removing the excess processing solution, for example, a squeeze roller or a drying means, for example, a hot air apparatus, subsequently to the development processing means.

### [Plate making method]

The lithographic printing plate precursor is exposes imagewise and then subjected to development processing with the processing solution according to the invention to prepare a lithographic printing plate.

In general, the development processing includes (a) a method of developing with an alkali developer (having pH higher than 11), (b) a method of developing with a developer having pH of 2 to 11, and (c) a method (on-press development) of developing by supplying dampening water and/or ink on a printing machine.

According to a conventional developing process using an alkali developer as the method (a), a protective layer is removed in a pre-water washing step, the alkali development is conducted, the alkali is removed by washing with water in a post-water washing step, gum solution treatment is conducted and drying is conducted in a drying step.

The processing solution according to the invention ordinarily has pH of 2 to 11, preferably pH of 7 to 10.8 and more preferably pH of 8.5 to 10.5.

According to the invention, the development and gum solution treatment can be conducted at the same time by incorporating a surfactant other than the compound represented by formula (1) and the compound represented by formula (2) or a water-soluble polymer compound into the processing solution. Therefore, the post-water washing step is not particularly necessary, and after conducting the development and gum solution treatment with one solution, the drying step can be performed. Moreover, since the removal of protective layer can also be conducted simultaneously with the development and gum solution treatment, the pre-water washing step is also not particularly necessary.

Specifically, the lithographic printing plate precursor is subjected to the development processing with the developer having pH of 2 to 11 to remove together the protective layer and the unexposed area of the photosensitive layer and the resulting lithographic printing plate is immediately mounted on a printing machine to perform printing.

It is preferred that after the development and gum treatment, the excess processing solution is removed using a squeeze roller, followed by conducting drying. The development of the lithographic printing plate precursor is performed at temperature ordinarily from 0 to 60°C, preferably from about 15 to about 40°C, using, for example, a method wherein the exposed lithographic printing plate precursor is immersed in the processing solution and rubbed with a brush or a method wherein the processing solution is splayed to the exposed lithographic printing plate precursor and the exposed lithographic printing plate precursor is rubbed with a brush. The processing by an automatic processor in such a manner is advantageous in view of being free from the measures against development scum resulting from the protective layer and/or photosensitive layer encountered in case of (c) on-press development.

Further, in the plate making process of the lithographic printing plate precursor according to the invention, the entire surface of the lithographic printing plate precursor may be heated, if desired, before or during the exposure or between the exposure and the development. By the heating, the image-forming reaction in the photosensitive layer is accelerated and advantages, for example, improvements in the sensitivity and printing durability and stabilization of the sensitivity are achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the non-image area is also cured. The heating after the development can be performed using very strong conditions. Ordinarily, the heat treatment is carried out in a temperature range of 100 to 500°C. When the temperature is too low, a sufficient effect of strengthening the image may not be obtained, whereas when it is excessively high, problems of deterioration of the support and thermal decomposition of the image area may occur.

In advance of the above-described development processing, the lithographic printing plate precursor is imagewise exposed with laser through a transparent original having a line image, a halftone dot image or the like, or imagewise exposed, for example, by scanning of laser beam based on digital data.

The wavelength of the exposure light source is preferably from 300 to 450 nm or from 750 to 1,400 nm. In case of exposing with light of 300 to 450 nm, the lithographic printing plate precursor having a photosensitive layer containing a sensitizing dye having an absorption maximum in the wavelength range is used. In case of exposing with light of 750 to 1, 400 nm, the lithographic printing plate precursor containing an infrared absorbing agent which is a sensitizing dye having an absorption maximum in the wavelength range is used. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

Now, the composition of the lithographic printing plate precursor (photosensitive material) preferably used in the method according to the invention is described below.

The lithographic printing plate precursor preferably used in the method according to the invention includes a negative type lithographic printing plate precursor comprising a hydrophilic support and a photosensitive layer containing (i), (ii), (iii) and (iv) shown below.
(i) a sensitizing dye,
(ii) a polymerization initiator,
(iii) a polymerizable compound,
(iv) a binder polymer.

### (A) Sensitizing dye

The photosensitive layer according to the invention preferably contains a sensitizing dye. The sensitizing dye can be used without particular limitation as far as it absorbs light at the image exposure to form the excited state and provides energy to a polymerization initiator described hereinafter with electron transfer, energy transfer or heat generation thereby improving the polymerization initiation function. Particularly, a sensitizing dye having an absorption maximum in a wavelength range of 300 to 450 nm or 750 to 1,400 nm is preferably used.

Examples of the sensitizing dye having an absorption maximum in a wavelength range of 300 to 450 nm include merocyanine dyes, benzopyranes, coumarins, aromatic ketones and anthracenes.

Of the sensitizing dyes having an absorption maximum in a wavelength range of 300 to 450 nm, a dye represented by formula (IX) shown below is more preferable in view of high sensitivity.

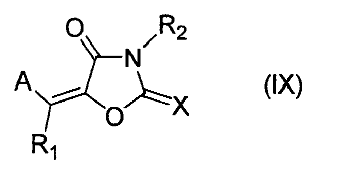

In formula (IX), A represents an aromatic cyclic group which may have a substituent or a heterocyclic group which may have a substituent, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

The formula (IX) will be described in more detail below.

R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Now, A in formula (IX) is described below. A represents an aromatic cyclic group which may have a substituent or a heterocyclic group which may have a substituent. The aromatic cyclic group which may have a substituent or heterocyclic group which may have a substituent are same as the substituted or unsubstituted aryl group and substituted or unsubstituted aromatic heterocyclic residue described for any one of R₁, R₂ and R₃ in formula (IX), respectively.

Specific examples of the sensitizing dye preferably include compounds described in Paragraph Nos. [0047] to [0053] of JP-A-2007-58170.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

Next, the sensitizing dye having an absorption maximum in a wavelength range of 750 to 1,400 (hereinafter, also referred to as an "infrared absorbing agent") preferably used in the invention is described in detail below. The infrared absorbing agent used is preferably a dye or pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

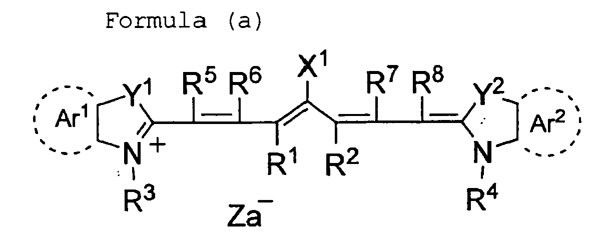

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

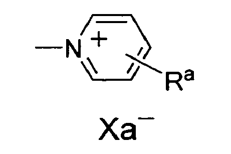

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms. It is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. In view of the availability of raw materials, a hydrogen atom is preferred. Za⁻ represents a counter anion. However, Za⁻ is not necessary when the cyanine dye represented by formula (a) has an anionic substituent in the structure thereof and neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer. As the counter ion, that does not contain a halide ion is particularly preferred.

Specific examples of the cyanine dye represented by formula (a), which can be preferably used in the invention, include those described in Paragraph Nos. [0017] to [0019] of JP-A-2001-133969.

Further, other particularly preferable examples include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

The amount of the sensitizing dye added is preferably from 0.05 to 30 parts by weight, more preferably from 0.1 to 20 parts by weight, most preferably from 0.2 to 10 parts by weight, per 100 parts by weight of the total solid content of the photosensitive layer.

### (B) Polymerization initiator

The photosensitive layer according to the invention contains a polymerization initiator (hereinafter, also referred to as an initiator compound). A photopolymerization initiator and a radical polymerization initiator are preferably used in the invention.

As the initiator compound according to the invention, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferable, and the hexaarylbiimidazole compound is particularly preferable. The polymerization initiators may be appropriately used in combination of two or more thereof.

The hexaarylbiimidazole compound includes, for example, lophine dimers described in JP-B-45-37377 (the term "JP-B" as used herein means an "examined Japanese patent publication") and JP-B-44-86516, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biim idazole, 2,2'-bis(o,o'-dichlorophenyl)-4,4',5,5'-tetraphenylbiimidazol e, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimid azole.

The hexaarylbiimidazole compound is particularly preferably used together with the sensitizing dye having an absorption maximum in a wavelength range of 300 to 450 nm.

The onium salt preferably used in the invention includes a sulfonium salt, an iodonium salt and a diazonium salt. Particularly, a diaryliodonium salt and a triarylsulfonium salt are preferably used. The onium salt is particularly preferably used together with the infrared absorbing agent having an absorption maximum in a wavelength range of 750 to 1,400 nm.

In addition, polymerization initiators described in Paragraph Nos. [0071] to [0129] of JP-A-2007-206217 are preferably used.

The polymerization initiators are preferably used individually or in combination of two or more thereof according to the invention.

The amount of the polymerization initiator used in the photosensitive layer according to the invention is preferably from 0.01 to 20% by weight, more preferably from 0.1 to 15% by weight, still more preferably from 1. 0 to 10% by weight, based on the total solid content of the photosensitive layer.

### (C) Polymerizable compound

The polymerizable compound for use in the photosensitive layer according to the invention is an addition-polymerizable compound having at least one ethylenically unsaturated double bond, and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include unsaturated carboxylic acids (for example, acrylic acid, methacrylic acid, itaconic acid, crotonic acid, isocrotonic acid or maleic acid) and esters or amides thereof. Preferably, esters of an unsaturated carboxylic acid with a polyhydric alcohol compound and amides of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C (R₄) COOCH₂CH (R₅) OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used.

Details of the method of using the polymerizable compound, for example, selection of the structure, individual or combination use or an amount added, can be appropriately determined in accordance with the characteristic design of the final lithographic printing plate precursor. The polymerizable compound is used preferably in a range of 5 to 75% by weight, more preferably in a range of 25 to 70% by weight, particularly preferably in a range of 30 to 60% by weight, based on the total solid content of the photosensitive layer.

### (D) Binder polymer

The photosensitive layer according to the invention contains a binder polymer. As the binder polymer, a polymer capable of holding the components of photosensitive layer on a support and capable of being removed by the processing solution is used. The binder polymer used includes a (meth) acrylic polymer, a polyurethane resin, a polyvinyl alcohol resin, a polyvinyl butyral resin, a polyvinyl formal resin, a polyamide resin, a polyester resin and an epoxy resin. Particularly, a (meth) acrylic polymer and a polyurethane resin are preferably used.

The term "(meth)acrylic polymer" as used herein means a copolymer containing as a polymerization component, (meth) acrylic acid or a (meth)acrylic acid derivative, for example, a (meth)acrylate (including, for example, an alkyl ester, aryl ester and allyl ester), (meth)acrylamide or a (meth)acrylamide derivative. The term "polyurethane resin" as used herein means a polymer formed by a condensation reaction of a compound having two or more isocyanate groups and a compound having two or more hydroxy groups.

One preferable example of the binder polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a carboxylic acid group is preferable. As the repeating unit, a repeating unit represented by formula (I) shown below is preferably used.

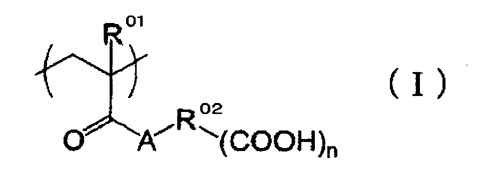

In formula (I), R⁰¹ represents a hydrogen atom or a methyl group, R⁰² represents a single bond or an n+1 valent connecting group, A represents an oxygen atom or -NR⁰³-, wherein R⁰³ represents a hydrogen atom or a monovalent hydrocarbon group having from 1 to 10 carbon atoms, and n represents an integer of 1 to 5.

The connecting group represented by R⁰² in formula (I) is constructed from a carbon atom, a hydrogen atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via an amido bond or an ester bond. R⁰² is preferably a single bond, an alkylene group or a substituted alkylene group, more preferably a single bond, an alkylene group having from 1 to 5 carbon atoms or a substituted alkylene group having from 1 to 5 carbon atoms, and most preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R⁰³ is preferably a hydrogen atom or a hydrocarbon group having from 1 to 5 carbon atoms, more preferably a hydrogen atom or a hydrocarbon group having from 1 to 3 carbon atoms, and most preferably a hydrogen atom or a methyl group. n is preferably from 1 to 3, more preferably 1 or 2, and most preferably 1.

A ratio (% by mole) of the copolymerization component having a carboxy group in the total copolymerization components of the binder polymer is preferably from 1 to 70% in view of developing property. Considering good compatibility between the developing property and printing durability, it is more preferably from 1 to 50%, and particularly preferably from 1 to 30%.

It is preferred that the binder polymer for use in the invention further contains a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bonding group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bonding group is preferable. The ethylenically unsaturated bonding group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause an addition-polymerization between the polymers directly or through a polymerization chain of the polymerizable compound, as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, and most preferably from 0.1 to 2.0 mmol, per g of the binder polymer.

The binder polymer for use in the invention may contain a polymerization unit of alkyl (meth)acrylate or aralkyl (meth)acrylate besides the polymerization unit having an acid group and the polymerization unit having a crosslinkable group. The alkyl group in the alkyl (meth) acrylate is preferably an alkyl group having from 1 to 5 carbon atoms and more preferably a methyl group. The aralkyl (meth)acrylate includes, for example, benzyl (meth)acrylate.

The binder polymer preferably has a weight average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by weight, more preferably from 10 to 70% by weight, still more preferably from 10 to 60% by weight, based on the total solid content of the photosensitive layer, from the standpoint of good strength of the image area and good image-forming property.

The total content of the polymerizable compound and the binder polymer is preferably 80% by weight or less based on the total solid content of the photosensitive layer. When it exceeds 80% by weight, decrease in the sensitivity and deterioration in the developing property may be caused sometimes. The total content is more preferably from 35 to 75% by weight.

### (Other components of photosensitive layer)

The photosensitive layer preferably further contains a chain transfer agent. As the chain transfer agent, for example, compounds having SH, PH, SiH or GeH in their molecules are used. The compound donates hydrogen to a low active radical species to generate a radical or is oxidized and deprotonized to generate a radical.

In particular, a thiol compound (for example, a 2-mercaptobenzimidazole, a 2-mercaptobenzthiazole, a 2-mercaptobenzoxazole, a 3-mercaptotriazole or a 5-mercaptotetrazole) is preferably used as the chain transfer agent in the photosensitive layer according to the invention.

Into the photosensitive layer according to the invention, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer or chain transfer agent for increasing sensitivity, and a plasticizer. As the additives, known compounds are used and, for example, compounds described in Paragraph Nos. [0161] to [0215] of JP-A-2007-206217 are used.

### <Formation of photosensitive layer>

The photosensitive layer is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by weight.

The coating amount (solid content) of the photosensitive layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### <Protective layer>

In the lithographic printing plate precursor, a protective layer (oxygen-blocking layer) is preferably provided on the photosensitive layer in order to prevent diffusion and penetration of oxygen which inhibits the polymerization reaction at the time of exposure. As a material for the protective layer, a water-soluble polymer compound relatively excellent in crystallizability is preferably used. Specifically, when polyvinyl alcohol is used as a main component, the best results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and water solubility. Also, polyvinyl alcohol may partly have other copolymer component. Polyvinyl alcohol is obtained by hydrolysis of polyvinyl acetate. As specific examples of the polyvinyl alcohol, those having a hydrolysis degree of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferable embodiment, the content of polyvinyl alcohol in the protective layer is from 20 to 95% by weight, and more preferably from 30 to 90% by weight.

Also, known modified polyvinyl alcohol can be preferably used. Particularly, an acid-modified polyvinyl alcohol having a carboxylic acid group or a sulfonic acid group is preferably used. As a component used as a mixture with polyvinyl alcohol, polyvinyl pyrrolidone or a modified product thereof is preferable from the viewpoint of the oxygen-blocking property and removability by development. The content thereof is ordinarily from 3.5 to 80% by weight, preferably from 10 to 60% by weight, more preferably from 15 to 30% by weight, in the protective layer.

As other component of the protective layer, glycerin, dipropylene glycol or the like can be added in an amount corresponding to several % by weight of the water-soluble polymer compound to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount corresponding to several % by weight of the water-soluble polymer compound.

Further, it is also preferred to incorporate an inorganic stratiform compound into the protective layer of the lithographic printing plate precursor for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

The coating amount of the protective layer is preferably in a range of 0.05 to 10 g/m² in terms of the coating amount after drying. When the protective layer contains the inorganic stratiform compound, it is more preferably in a range of 0.1 to 5 g/m², and when the protective layer does not contain the inorganic stratiform compound, it is more preferably in a range of 0.5 to 5 g/m²_{.}

### [Support]

The support for use in the lithographic printing plate precursor is not particularly restricted as long as it is a dimensionally stable plate-like hydrophilic support. Particularly, an aluminum plate is preferable. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-2007-206217 are preferably used.

The center line average roughness of support is preferably from 0.10 to 1.2 µm. In the range described above, good adhesion property to the photosensitive layer, good printing durability and good resistance to stain are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### [Hydrophilizing treatment of support and undercoat layer]

As for the lithographic printing plate precursor, in order to increase hydrophilicity of the non-image area and to prevent printing stain, it is preferred to conduct hydrophilizing treatment of the surface of support or to provide an undercoat layer between the support and the photosensitive layer.

The hydrophilizing treatment of the surface of support includes an alkali metal silicate treatment wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. The compound preferably further includes a polymerizable group in order to increase the adhesion property to the photosensitive layer. Also, a compound having a hydrophilicity-imparting group, for example, an ethylene oxide group is exemplified as a preferable compound. These compounds may be low molecular weight compounds or polymers. Further, a silane coupling agent having an addition-polymerizable ethylenic double bond reactive group described in JP-A-10-282679 and a phosphorus compound having an ethylenic double bond reactive group described in JP-A-2-304441 are preferably used.
A coating amount (solid content) of the undercoat layer is preferably from 0.1 to 100 mg/m², and more preferably from 1 to 30 mg/m²_{.}

### [Backcoat layer]

After applying the surface treatment to the support or forming the undercoat layer on the support, a backcoat layer can be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si(OC₄H₉)₄ is preferred since the starting material is inexpensive and easily available.

### EXAMPLES

The present invention will be described in more detail with reference to the following examples, but the invention should not be construed as being limited thereto.

### Examples 1 to 13 and Comparative Examples 1 to 11

### <Preparation of lithographic printing plate precursor>

### [Preparation of support]

An aluminum plate (JIS A1050) having a thickness of 0.3 mm was subjected to surface treatment according to the steps shown below.

### (a) Alkali etching treatment

Alkali etching treatment of the aluminum plate was conducted by spraying an aqueous solution having sodium hydroxide concentration of 26% by weight, aluminum ion concentration of 6.5% by weight and temperature of 70°C to dissolve the aluminum plate in an amount of 10 g/m², followed by washing with water by spraying.

### (b) Desmut treatment

Desmut treatment of the aluminum plate was conducted by spraying an aqueous nitric acid solution having temperature of 30°C, followed by washing with water by spraying. As the aqueous nitric acid solution for the desmut treatment, a waste solution from a step of electrochemical surface roughening treatment was used.

### (c) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by weight of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric quantity was 220 C/dm² in terms of the total electric quantity during the aluminum plate functioning as an anode. To the auxiliary anode, 5% of the current from the electric source was divided. Subsequently, the aluminum plate was washed with water by spraying.

### (d) Alkali etching treatment

Alkali etching treatment of the aluminum plate was conducted by spraying an aqueous solution having sodium hydroxide concentration of 5% by weight, aluminum ion concentration of 0.5% by weight and temperature of 50°C, followed by washing with water by spraying.

### (e) Desmut treatment

Desmut treatment of the aluminum plate was conducted at 35°C for 4 seconds. As an aqueous sulfuric acid solution for the desmut treatment, a waste solution generated in a step of anodizing treatment was used.

### (f) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2 . 4 m each). The electrolytic solution supplied to the first electrolytic unit and second electrolytic unit was an aqueous solution having sulfuric acid concentration of 50 g/liter (containing 0.5% by weight of aluminum ion) and the solution temperature was 20°C. Subsequently, the aluminum plate was washed with water by spraying. The amount of the final anodic oxide film was 2.7 g/m²_{.}

### (g) Treatment with polyvinylphosphonic acid

The aluminum plate was immersed in an aqueous solution containing 4 g/liter of polyvinylphosphonic acid at 40°C for 10 seconds, washed with demineralized water having calcium ion concentration of 75 ppm at 20°C (washing time: 4 sec) and then with pure water at 20°C (washing time: 4 sec) and dried. The adhesion amount of calcium ion was 1.92 g/m².

The center line average roughness (Ra indication according to JIS B0601) of the support was measured using a stylus having a diameter of 2 µm and found to be 0.25 µm.

### [Formation of photosensitive layer]

Coating solution 1 for photosensitive layer having the composition shown below was coated on the support using a bar and dried by a hot air drying device at 100°C for one minute to form a photosensitive layer having a dry coating amount of 1.4 g/m².

| <Coating solution 1 for photosensitive layer> | |
|---|---|
| Polymerizable Compound (M-1) shown below | 3.6 parts by weight |
| Binder Polymer (B-1) shown below (weight average molecular weight: 47,000) | 2.4 parts by weight |
| Sensitizing Dye (D-1) shown below | 0.32 parts by weight |
| Polymerization Initiator (I-1) shown below | 0.61 parts by weight |
| Chain Transfer Agent (S-2) shown below | 0. 57 parts by weight |
| N-Nitrosophenylhydroxylamine aluminum salt | 0.020 part by weight |
| Dispersion of ε-phthalocyanine shown below | 0.71 parts by weight |
| Fluorine-Based Surfactant (F-1) shown below (weight average molecular weight: 11,000) | 0.016 part by weight |
| Methyl ethyl ketone | 47 parts by weight |
| Propylene glycol monomethyl ether | 45 parts by weight |

The dispersion of ε-phthalocyanine is a dispersion comprising 15 parts by weight of ε-phthalocyanine, 10 parts by weight of dispersing agent (allyl methacrylate/methacrylic acid copolymer (weight average molecular weight: 60,000, copolymerization molar ratio: 83/17) and 15 parts by weight of cyclohexanone.

The structures of Polymerizable compound (M-1), Binder Polymer (B-1), Sensitizing Dye (D-1), Polymerization Initiator (I-1), Chain Transfer Agent (S-2) and Fluorine-Based Surfactant (F-1) used in Coating solution 1 for photosensitive layer are shown below, respectively.
M-1

### Mixture of the following compounds:

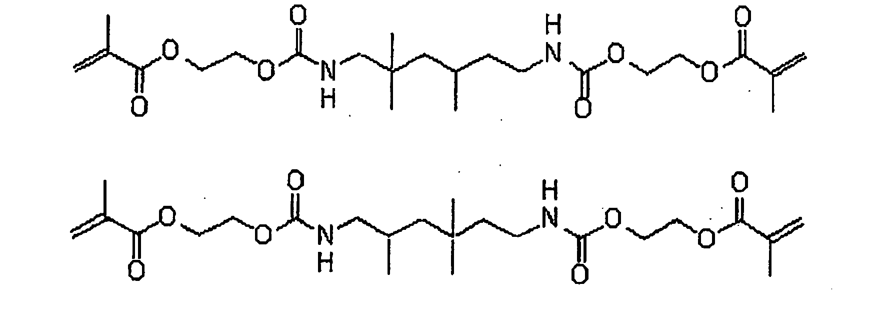

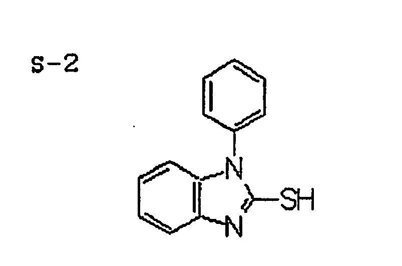

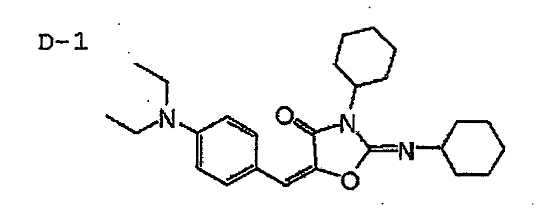

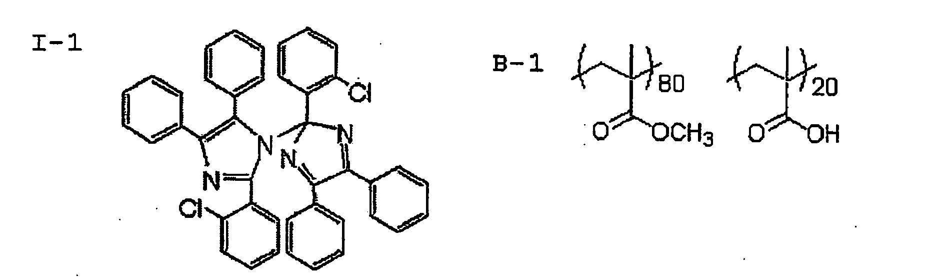

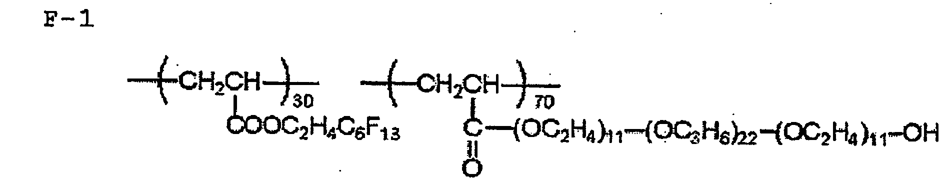

### [Formation of protective layer]

A coating solution for protective layer having the composition shown below was coated on the photosensitive layer using a bar and dried by a hot air drying device at 125°C for 34 seconds to form a protective layer having a dry coating amount of 1.8 g/m², thereby preparing Lithographic printing plate precursor-1.

| <Coating solution for protective layer> | |
|---|---|
| Dispersion of mica shown below | 1.67 g |
| Sulfonic acid-modified polyvinyl alcohol [Goseran CKS-50, produced by Nippon Synthetic Chemical Industry Co., Ltd. (saponification | 2.17 g |
| degree: 99% by mole; average polymerization degree: 300; modification degree: about 0.4% by mole)] | |
| Surfactant (Emalex 710, produced by Nihon Emulsion Co., Ltd.) | 0.16 g |
| Water | 43.6 g |

### (Dispersion of mica)

In 368 g of water was added 32 g of synthetic mica (SOMASIF ME-100, produced by CO-OP Chemical Co., Ltd.; aspect ratio: 1, 000 or more) and the mixture was dispersed using a homogenizer until the average particle diameter (measured by a laser scattering method) became 0.5 µm to obtain dispersion of mica.

Lithographic printing plate precursor-2 was prepared in the same manner as in the preparation of Lithographic printing plate precursor-1 except for changing the polymerizable compound, binder polymer and sensitizing dye used in the photosensitive layer of Lithographic printing plate precursor-1 to Polymerizable Compound (M-2), Binder Polymer (B-2) and Sensitizing Dye (2) shown below, respectively.
Binder Polymer (B-2): Copolymer of vinyl butyral/vinyl alcohol/vinyl acetate esterified with trimellitic acid in 13. 9 % based on weight (Koma30, produced by Claliant Co., Ltd.)

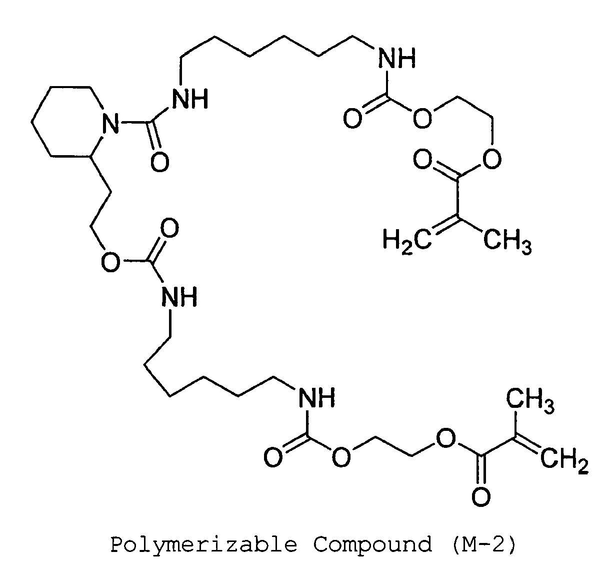

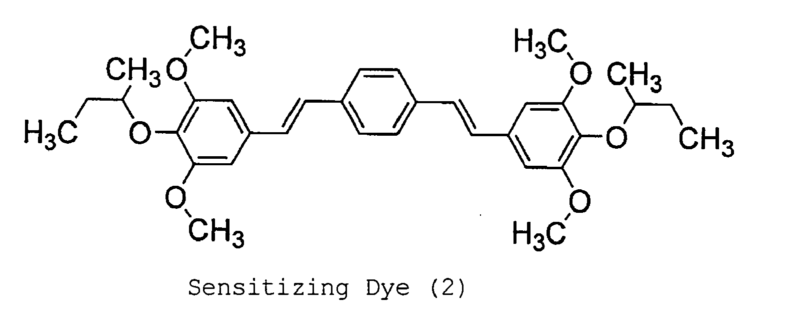

### [Exposure, Development and Printing]

Each of the lithographic printing plate precursors was subjected to image exposure by a violet semiconductor laser plate setter Vx9600 (having InGaN semiconductor laser (emission wavelength: 405nm±10 nm/output: 30 mW)) produced by FFEI. The image drawing was performed at resolution of 2,438 dpi using FM screen (TAFFETA 20, produced by Fuji Film Co., Ltd.) in a plate surface exposure amount of 0.05 mJ/cm².

The exposed lithographic printing plate precursor was subjected to preheat at 100°C for 30 seconds and then subjected to development processing in an automatic development processor having a structure as shown in Fig. 1 using each processing solution having the composition shown in Table 1. The automatic development processor had one brush roller having an outer diameter of 50 mm and being implanted with fiber of polybutylene terephthalate (bristle diameter: 200 µm, bristle length: 17 mm), and the brush roller was rotated at 200 rpm (peripheral velocity at the tip of brush: 0.52 m/sec) in the same direction as the transporting direction of the lithographic printing plate precursor. The temperature of the processing solution was 28°C. The transportation of the lithographic printing plate precursor was conducted at transporting speed of 100 cm/min. After the development processing, the lithographic printing plate was dried in a drying unit. The drying temperature was 80°C.

The control of pH of each processing solution was conducted with sodium hydroxide and phosphoric acid. The total amount of each processing solution was made one liter by finally adding ion-exchanged water.

The lithographic printing plate precursor used is also shown in Table 1.

In Table 1, the amount of the component is indicated in g/l. The solid content concentration is indicated in % by weight.

The mixing ratio (I:II) means a weight ratio of compound represented by formula (1) : compound represented by formula (2).

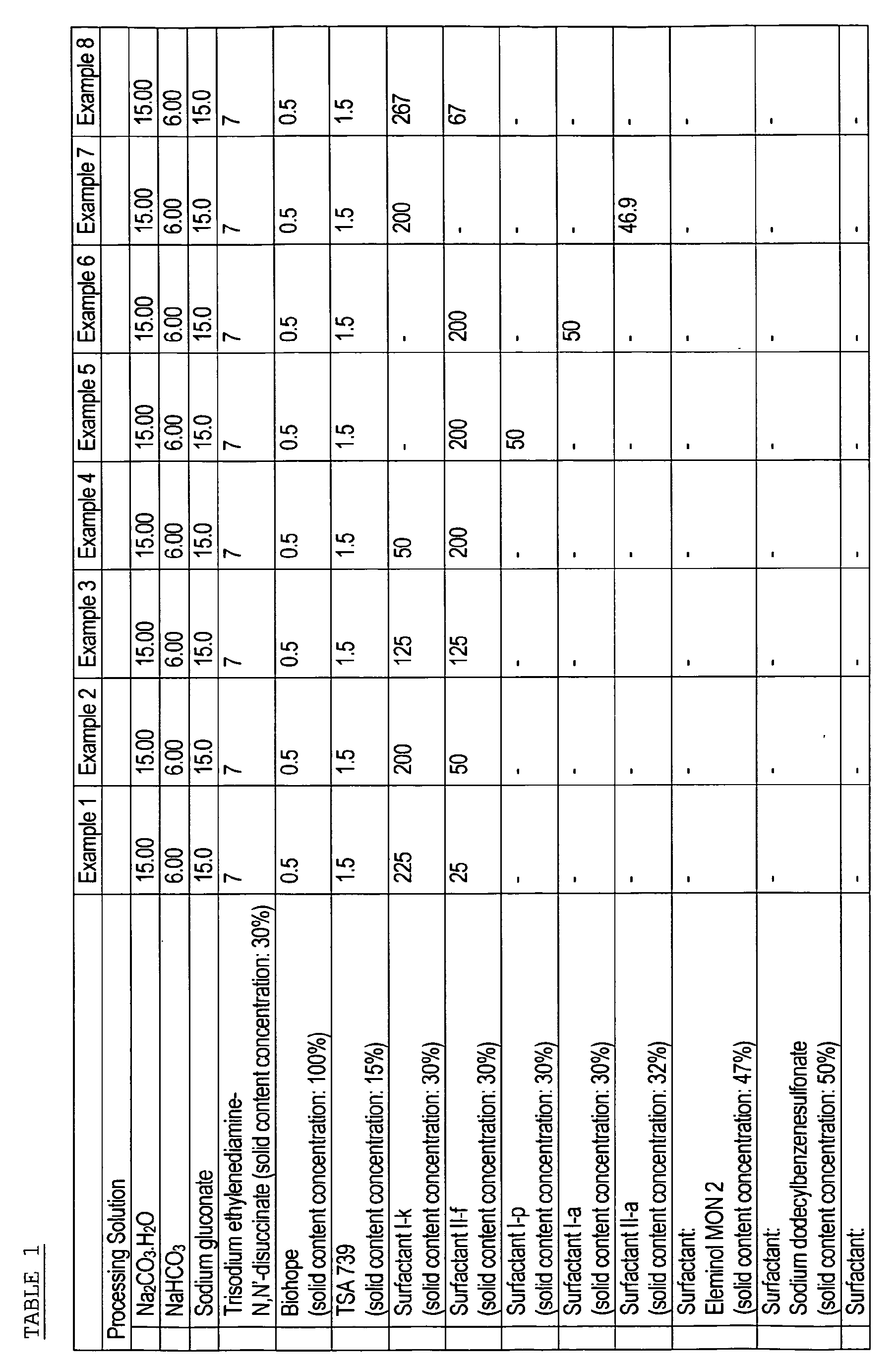

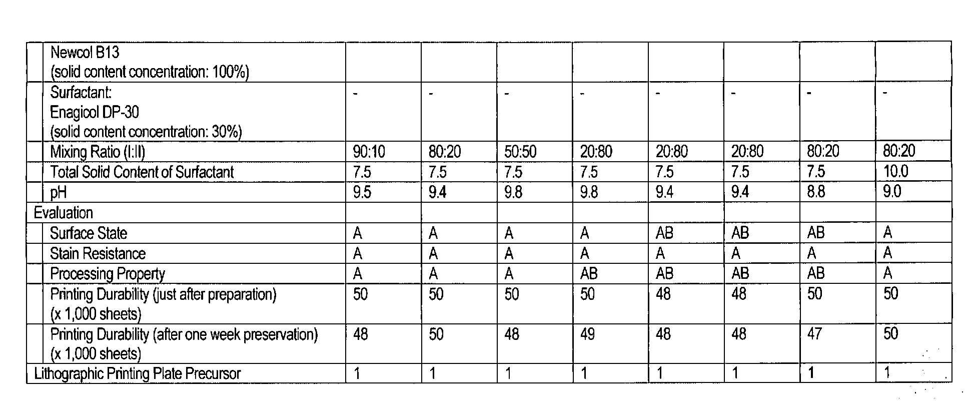

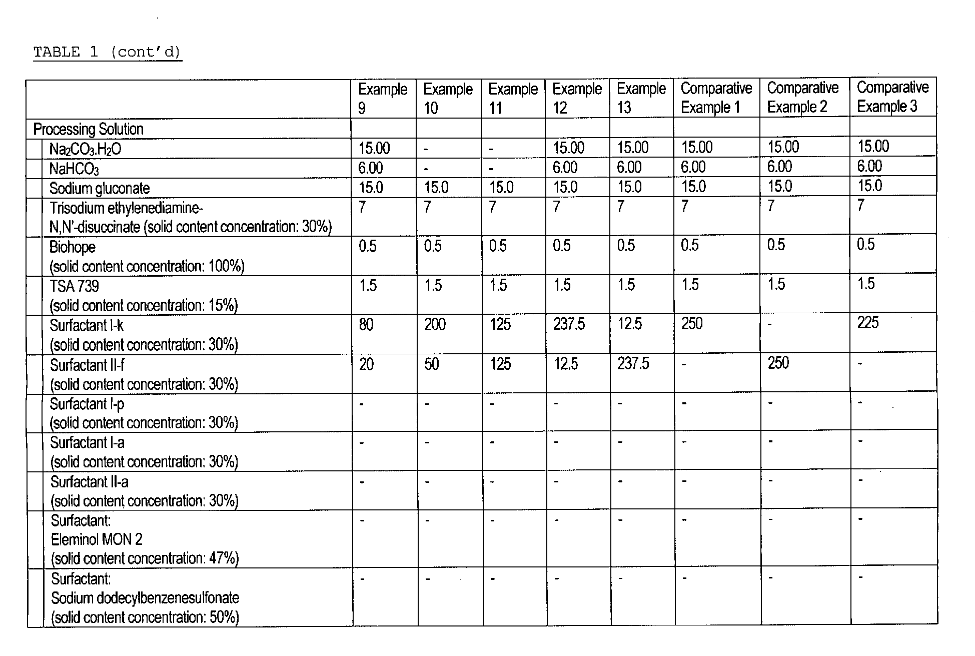

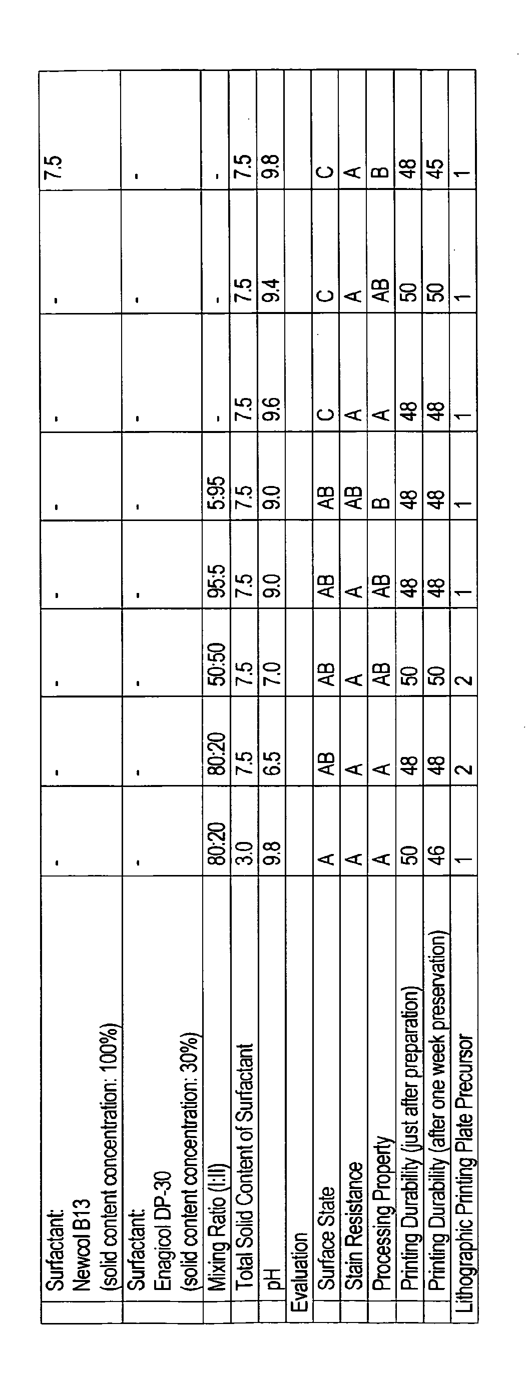

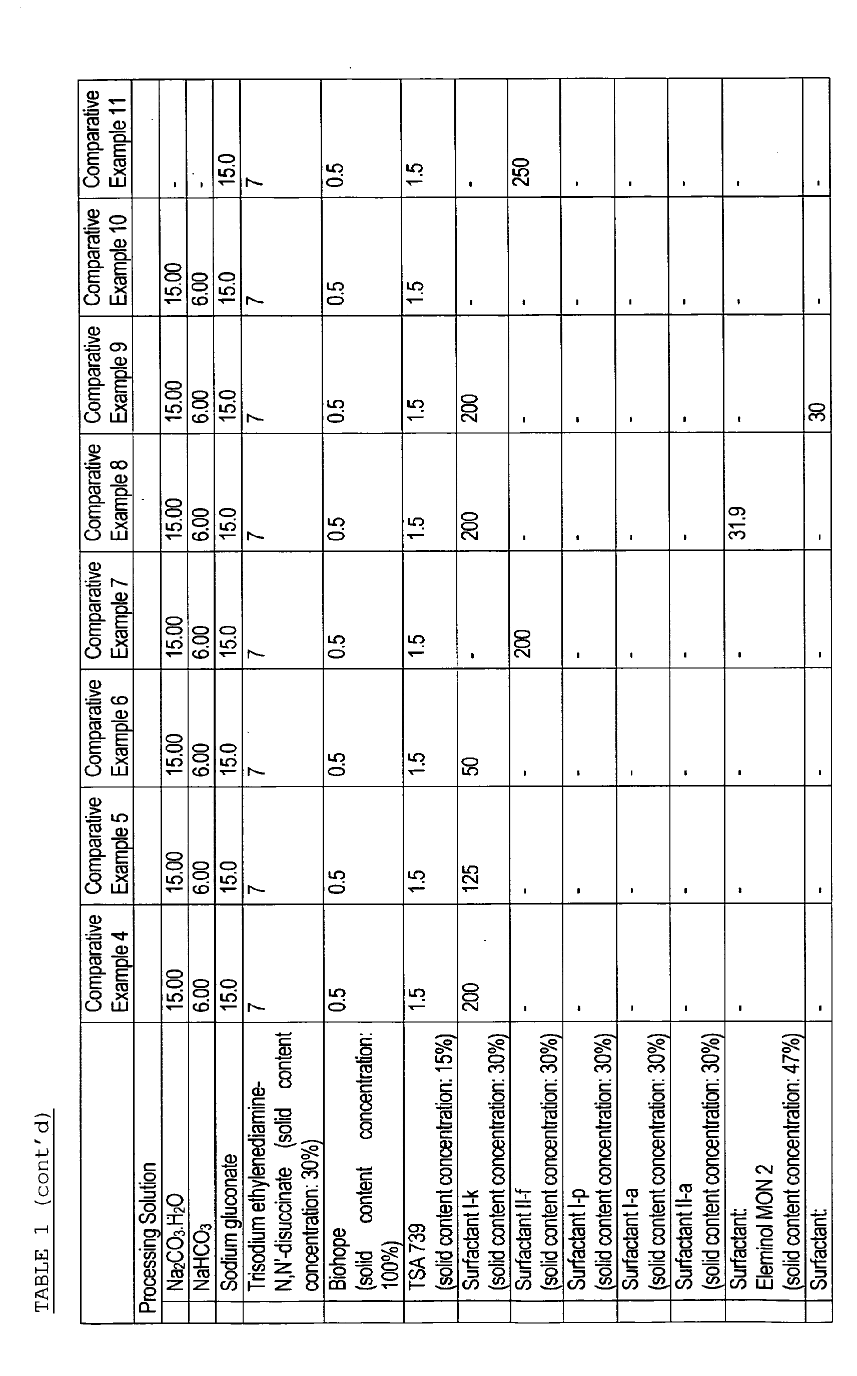

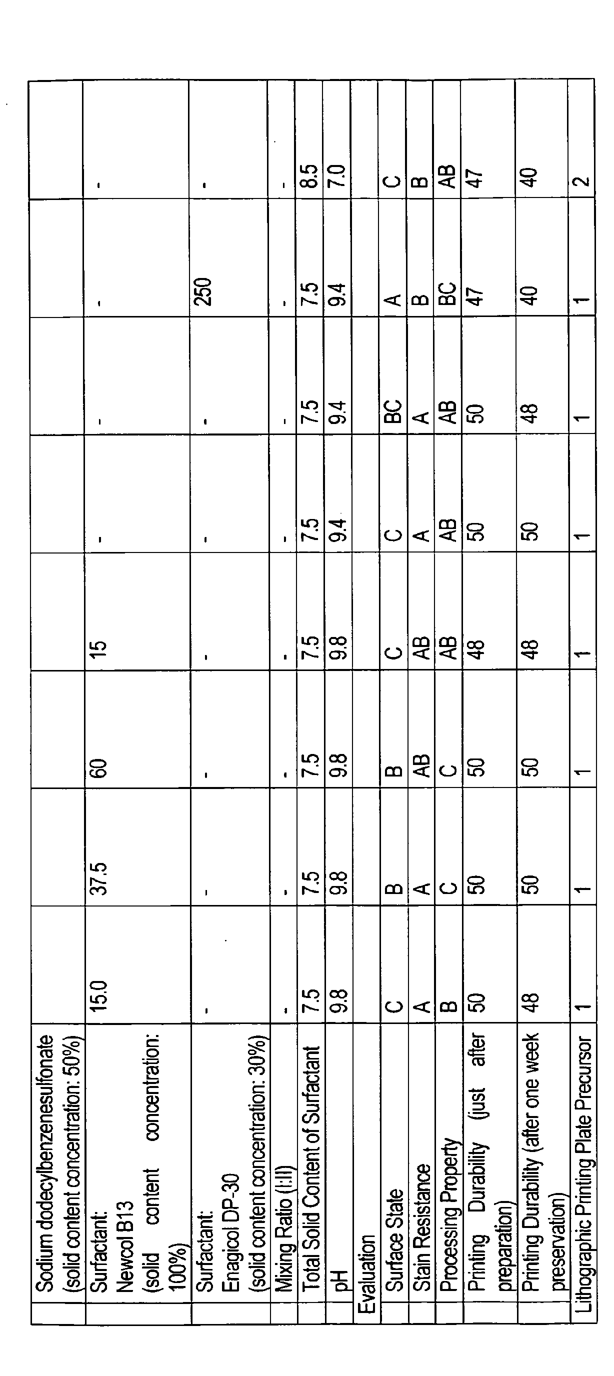

The components of the processing solutions shown in Table 1 are described below.
Surfactant I-k: Softazoline LPB-R (produced by Kawaken Fine Chemicals Co, Ltd.)
Surfactant II-f: Softazoline LAO (produced by Kawaken Fine Chemicals Co, Ltd.)
Surfactant I-p: Vista MAP (produced by Kawaken Fine Chemicals Co, Ltd.)
Surfactant I-a: Takesaaf C-157L (produced by Takemoto oil & Fat Co., Ltd.)
Surfactant II-a: Amogen AOL (produced by Dai-ichi Kogyo Seiyaku Co., Ltd.)
Sodium gluconate (produced by Fuso Chemical Co., Ltd.)
Octaquest E30 (produced by Innospec Specialty Chemicals Ltd.)
Biohope (preservative and antifungal agent, produced by K.I Chemical Industry Co., Ltd.)
TSA 739 (defoaming agent, produced by GE Toshiba Silicones Co., Ltd.)
Pionin A41S (produced by Takemoto Oil & Fat Co., Ltd.)
Enagicol DP-30 (sodium laurylaminodipropionate, produced by Lion Corp.)
Newcol B13 (polyoxyethylene aryl ether, produced by Nippon Nyukazai Co., Ltd.)
Eleminol MON 2 (sodium alkyldiphenyletherdisulfonate, produced by Sanyo Chemical Industries, Ltd.)
Sodium dodecylbenzenesulfonate (produced by Takemoto Oil & Fat co., Ltd.)

The lithographic printing plate obtained was mounted on a printing machine (SOR-M, produced by Heidelberg) and printing was performed at a printing speed of 6,000 sheets per hour using dampening water (EU-3 (etching solution, produced by Fuji Film Co., Ltd.)) /water/isopropyl alcohol = 1/89/10 (by volume ratio)) and TRANS-G (N) black ink (produced by Dainippon Ink & Chemicals, Inc.).

### [Evaluation]

Using the lithographic printing plate precursor, the surface state, stein resistance, processing property and printing durability were evaluated in the manner shown below.

### <Surface state>

The lithographic printing plate after the development processing was allowed to stand at temperature of 25°C and humidity of 60% for 4 days and then the surface state was evaluated according to the following criteria:
A: Case where good surface state was obtained without deposition of crystals in the halftone dot image.
B: Case where although slight unevenness of surface state was recognized in the halftone dot image, it is at the acceptable level. C: Case where unevenness of surface state was recognized in the halftone dot image.
AB: Intermediate level between A and B.
BC: Intermediate level between B and C.

### <Stain resistance>

The lithographic printing plate was subjected to the printing under the condition described above and after printing 10,000 sheets, stain on a blanket corresponding to the non-image area was visually evaluated according to the following criteria:
A: Case where no stain on the blanket was observed.
B: Case where stain on the blanket was hardly observed.
C: Case where stain on the blanket was observed.
AB: Intermediate level between A and B.

### <Processing property>

After the lithographic printing plate precursor was subjected to development processing in the automatic development processor under the condition described above in an amount of 500 m² spending one week, the occurrence of scum adhered on the tank wall of the automatic development processor was visually observed. The scum occurred was mainly caused by the binder of the protective layer. The evaluation was conducted according to the following criteria:
A: Case where no scum was observed.
B: Case where although the scum was observed, it was at the acceptable level.
C: Case where the severe scum was observed.
AB: Intermediate level between A and B.
BC: Intermediate level between B and C.

### <Printing durability>

As increase in the number of printed materials, the image of the photosensitive layer formed on the lithographic printing plate was gradually abraded to cause decrease in the ink receptivity, resulting in decrease of ink density of the image on the printed material. A number of printed materials obtained until the ink density (reflection density) decreased by 0.1 from that at the initiation of printing was determined to evaluate the printing durability (just after preparation). Also, after the preparation of the lithographic printing plate, it was allowed to stand under an environment of temperature of 25°C and humidity of 60% for one week and then subjected to the printing under the condition described above to evaluate the printing durability (after one week preservation) in the same manner.

The results obtained are shown in Table 1.

From the results shown in Table 1, it can be seen that according to the method of preparing a lithographic printing plate of the invention, the surface state of the lithographic printing plate after the development processing is good, because of the good developing property printed materials without unevenness of halftone dot image are obtained, and the occurrence of scum in the developing tank is prevented. It is also found that the deterioration of printing durability due to the preservation of the lithographic printing plate after the development processing hardly arises.

## Claims

1. A processing solution for developing a lithographic printing plate precursor, comprising a compound represented by the following formula (1) and a compound represented by the following formula (2): 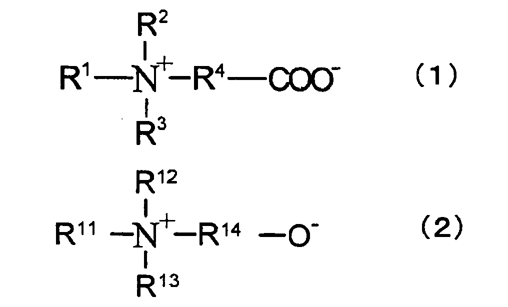 wherein, R¹ and R¹¹ each independently represents a hydrogen atom, an alkyl group or an alkyl group containing a connecting group which is selected from an ester bond, a carbonyl bond and an amido bond, provided that when R¹ and R¹¹ each independently represents an alkyl group or an alkyl group containing a connecting group, a total number of carbon atoms included is from 8 to 20, R² and R¹² each independently represents a hydrogen atom or an alkyl group, R³ and R¹³ each independently represents a group containing an ethylene oxide group or an alkyl group, and R⁴ and R¹⁴ each independently represents an alkylene group or a single bond.

2. The processing solution for developing a lithographic printing plate precursor as claimed in claim 1, wherein at least one of the compound represented by the formula (1) and the compound represented by the formula (2) has an amido bond.

3. The processing solution for developing a lithographic printing plate precursor as claimed in claim 1 or 2, wherein a weight ratio of an amount of the compound represented by the formula
(1) contained in the processing solution and an amount of the compound represented by the formula (2) contained in the processing solution is from 5:95 to 95:5.

4. The processing solution for developing a lithographic printing plate precursor as claimed in any one of claims 1 to 3, which has pH of from 8.5 to 10.5.

5. The processing solution for developing a lithographic printing plate precursor as claimed in any one of claims 1 to 4, wherein a total amount of the compound represented by the formula (1) and the compound represented by the formula (2) is from 0.01 to 15% by weight in the processing solution.

6. The processing solution for developing a lithographic printing plate precursor as claimed in any one of claims 1 to 5, which further comprises a surfactant or a water-soluble polymer compound.

7. A method for preparing a lithographic printing plate, comprising:
imagewise exposing a negative type lithographic printing plate precursor comprising a hydrophilic support and a photosensitive layer containing (i) a sensitizing dye, (ii) a photopolymerization initiator, (iii) a polymerizable compound and (iv) a binder polymer; and
developing the exposed lithographic printing plate precursor with the processing solution as claimed in any one of claims 1 to 6.

8. The method for preparing a lithographic printing plate as claimed in claim 7, wherein the developing with the processing solution is conducted by one solution.
